# EUROPÄISCHE PATENTSCHRIFT

(11) **EP 2 118 332 B1**
(45) Veröffentlichungstag und Bekanntmachung des Hinweises auf die Patenterteilung: **28.09.2011**
(21) Anmeldenummer: 08706036.4
(22) Anmeldetag: 29.02.2008
(51) Int. Cl.: C23C 8/20, C23C 8/24, C23C 8/44, C23C 16/02, C23C 8/10, C23C 8/16, C23C 8/36, C23C 8/80

(54) **VERFAHREN ZUR HERSTELLUNG EINER BESCHICHTUNG**
METHOD FOR THE PRODUCTION OF A COATING
PROCÉDÉ DE PRODUCTION D'UN REVÊTEMENT

(30) Priorität: 01.03.2007 AT 3182007
(43) Veröffentlichungstag der Anmeldung: 18.11.2009
(73) Patentinhaber: Rübig Gmbh & Co Kg, 4600 Wels (AT)
(72) Erfinder: RÜBIG, Günter, A-4600 Wels (AT)
(74) Vertreter: Ofner, Clemens
(86) Internationale Anmeldenummer: PCT/AT2008/000068
(87) Internationale Veröffentlichungsnummer: WO 2008/104013

(56) Entgegenhaltungen:
- MORI H ET AL: "Increased adhesion of diamond-like carbon-Si coatings and its tribological properties" SURFACE & COATINGS TECHNOLOGY ELSEVIER SWITZERLAND, Bd. 149, Nr. 2-3, 15. Januar 2002 (2002-01-15), Seiten 225-230, XP002524718 ISSN: 0257-8972
- MELETIS E I ET AL: "Tribological characteristics of DLC films and duplex plasma nitriding/DLC coating treatments" SURFACE AND COATINGS TECHNOLOGY SWITZERLAND, Bd. 73, Nr. 1-2, Juli 1995 (1995-07), Seiten 39-45, XP002524719 ISSN: 0257-8972
- LEE, I.: "post-oxidizing treatments of the compound layer on the AISI 4135 steel produced by plasma nitrocarburizing" SURFACE AND COATINGS TECHNOLOGY, Bd. 188-189, 2004, Seiten 669-674, XP002524717

## Beschreibung

Die Erfindung betrifft ein Verfahren zur Herstellung einer Beschichtung auf Basis zumindest eines Werkstoffes ausgewählt aus einer Gruppe umfassend Silizium, Germanium, sowie die Oxide dieser Elemente, wobei diese gegebenenfalls dotiert werden, und insbesondere amorph hergestellt werden, auf zumindest einem Teilbereich einer Oberfläche eines metallischen Trägers, wobei in dem Träger gegebenenfalls vor der Abscheidung der Beschichtung zumindest im Bereich des Teilbereichs der Gehalt an Stickstoff erhöht wird, ein Werkstück, das nach diesem Verfahren herstellbar ist, umfassend einen metallischen Träger, der auf zumindest einem Teilbereich seiner Oberfläche eine derartige Beschichtung aufweist sowie die Verwendung dieses Werkstücks.

Metallische Oberflächen müssen unterschiedlichste Leistungsspektren erbringen. Um dies zu ermöglichen ist es üblich, einerseits die Oberfläche selbst, das heißt die oberflächennahen Schichten zu verändern, bspw. durch Nitrieren, um die Verschleißfestigkeit zu erhöhen. Andererseits ist es auch möglich Beschichtungen anzubringen, wobei damit einerseits der Schutz der darunter liegenden metallischen Oberfläche erreicht wird und andererseits über diese Oberflächenbeschichtung die jeweils erforderliche Eigenschaft der Oberfläche zur Verfügung gestellt wird. So ist es z.B. aus dem Stand der Technik zur Verbesserung der Tribologie einer metallischen Oberfläche bekannt, kohlenstoffhaltige Beschichtungen anzubringen. Aus dem großen Bereich derartiger Schichtmaterialien seien insbesondere die wasserstoffhältigen Kohlenstoffschichten erwähnt. Wegen der zum Teil diamantähnlichen Schichteigenschaften werden diese Schichten vielfach auch als DLC-Schichten (diamond like carbon) bezeichnet.

Zur weiteren Verbesserung derartiger Schichten wurden in der Literatur bereits Variationen hiervon beschrieben. Beispielsweise ist es möglich, durch den Einbau von Metallen in diese Schichten die elektrische Leitfähigkeit zu erhöhen. Durch den Einbau nichtmetallischer Elemente, wie z.B. Fluor, Silizium, Sauerstoff, Stickstoff oder Bor ist es möglich, die Oberflächenenergien, welche das Benetzungsverhalten bestimmen, derartiger Schichten zu modifizieren. Die Herstellung derartiger Schichten erfolgt üblicherweise, über plasmaaktivierte chemische Gasphasenabscheidung, auch bekannt unter PACVD-Technik.

Auch Sputterverfahren wurden bereits beschrieben, z.B. in der WO 03/064720 A, wobei als Target ein Kohlenstofftarget, insbesondere ein Graphittarget, eingesetzt und mit einer negativen Gleichspannung vorgespannt wird.

Wie aufgrund der chemischen Ähnlichkeit von Silizium zu Kohlenstoff zu erwarten, wurden im Stand der Technik auch bereits DLC-Schichten auf Siliziumbasis beschrieben, bspw. in "Increased adhesion of diamond-like carbon-Si coatings and its tribolgical properties; H. Mori, H. Tachikawa; Surface and Coatings Technology 149, 2002, 225 - 230" oder "Continuously deposited duplex coatings consitings of plasma nitriding and a-C:H:Si deposition; T. Michler, N. Grischke, H. Bewilogua, A. Hieke; Surface and Coatings Technology 111,1999,41 - 45".

Aus "Investigation of DLC-Si coatings in large-scale production using DC-PACVD equipment; K. Nakanishi, et al.; Surface and Coatings Technology 200,2006,4277-4281" ist bekannt, dass zur Verbesserung der Haftung der DLC Schicht der Träger durch Nitrieren und anschließendem Ionensputtern vorbehandelt wird.

Aus E.I. Meletis et al: Tribological characteristics of DLC films and duplex plasma nitriding/DLC coating treatments; Surface and Coatings Technology 73 (1995) 39-45 ist ein Verfahren zur Herstellung einer DLC Schicht auf einem Metallsubstrat mit verbesserter Haftung bekannt. Dazu wird die Oberfläche des Metallsubstrats einer Plasmanitrierung unterzogen. Auf die Nitridschicht wird unter Zwischenanordnung einer Si-Schicht die DLC-Schicht abgeschieden.

Insup Lee: Post-oxidizing treatments ofthe compound layer on the AISI 4135 steel produced by plasma nitrocarburizing; Surface and Coatings Technology 188-189 (2004) 669-674 beschreibt die Verbesserung des Korrosionswiderstandes einer durch Plasmanitrocarburieren erzeugten Schicht durch das nachträglich Oxidieren dieser Schicht in einem Sauerstoffplasma.

Aufgabe der Erfindung ist es, ein metallisches Werkstück mit verbesserten Oberflächeneigenschaften zur Verfügung zu stellen.

Diese Aufgabe der Erfindung wird jeweils eigenständig durch das eingangs genannte Verfahren zur Herstellung einer Beschichtung, bei dem zumindest der Teilbereich der Oberfläche, auf den die Beschichtung auf den metallischen Träger aufgebracht wird, vor Abscheidung derselben einer Oxidation unterzogen wird, sowie durch das Werkstück aus dem metallischen Träger, bei dem dieser zumindest in oberflächennahen Bereichen zumindest in dem für die Beschichtung vorgesehenen Teilbereich oxidierend vorbehandelt ist, gelöst. Durch die oxidative Vorbehandlung und die damit erzeugte Oxidschicht an der Oberfläche des metallischen Trägers wird eine verbesserte Haftung der, gegebenenfalls dotierten, silizium bzw. germaniumbasierten Schicht - es werden hierunter im Sinne der Erfindung generell auch die jeweiligen Oxidschichten, insbesondere SiO₂ und GeO₂, verstanden - unter Ausbildung von Vander-Waals Kräften zwischen Sauerstoff- und Silizium bzw. Germaniumatomen im Oberflächenbereich erreicht. Darüber hinaus wird mit diesem Schichtaufbau auch eine Verbesserung des Verschleißverhaltens sowie der Notlaufeigenschaften, wenn dieses Werkstück tribologisch beansprucht ist, erreicht, indem die Oberflächentopographie des Werkstückes durch diesen Schichtaufbau geändert wird. Dabei kann die Oberfläche von Spitzen und Verzahnungen, die aus der Vorbehandlung, insbesondere durch oxidieren, stammen über die Versiegelung befreit werden. Von Vorteil ist dabei, dass die Oberflächenrauhigkeit durch die Versiegelung selbst bei Bedarf unbeeinflusst erhalten werden kann bzw. ist es bei entsprechender Prozessführung möglich, dass die Oberflächenrauhigkeit verringert wird. Es wird aber auch die Oberflächenenergie reduziert, sodass die Adhäsionsneigung zu anderen Werkstoffen, wie z.B. Holz, Kunststoffen und Metallen, während der Verarbeitung derselben reduziert wird. Darüber hinaus kann dieses Schichtsystem mit der silizium bzw. germaniumbasierten Beschichtung aber auch als Haftvermittlerschicht für weitere Schichtaufbauten auf dem metallischen Träger verwendet werden, bspw. für weitere mittels Plasmatechnik abgeschiedene, oben erwähnte, mit Metallen, wie bspw. Titan oder Silizium, gegebenenfalls dotierte, wasserstoffhältige Kohlenstoffschichten (DLC-Schichten). Als Zusatzeffekt des erfindungsgemäßen Schichtsystems tritt der Vorteil auf, dass diese Teile ohne weitere Nachbehandlung eine gleichmäßige, schwarze bis tief-schwarze Oberfläche erhalten, ähnlich zu brünierten Oberflächen, und damit auch ein entsprechender optischer Effekt mit positiven Auswirkungen auf die Verkaufbarkeit derartiger Teile erzielt wird.

Zur Erhöhung der Tiefenwirkung und damit zur Verbesserung der Verschleißfestigkeit bzw. Erhöhung der Härte sowie zur Verbesserung der Korrosionsbeständigkeit des Trägers an sich sowie des gesamten Schichtsystems im Vergleich zu Werkstücken, welche an ihrer Oberfläche lediglich siliziumbasierende Beschichtungen aufweisen, ist es von Vorteil, wenn die Oxidation des Trägers nach der Nitrierung durchgeführt wird. Dies erfolgt in Zusammenwirkung mit der Beschichtung, die als Versiegelung der Oberfläche wirkt, wobei durch die oxidative Vorbehandlung des Werkstückes in der Folge Fehlstellen in der Oxidschicht des Werkstückes abgedeckt werden, also bspw. einer Eisenoxidschicht, wie z.B. Fe₃O₄,ab, welche in der Großserie verfahrensbedingt auftreten können. Derartige Fehlstellen werden z.B. als Poren in der Oberfläche des Werkstückes ausgebildet, wobei an diesen Poren der korrosive Angriff stattfindet.

Bevorzugt wird die Erhöhung des Stickstoffgehaltes in oberflächennahen Bereichen des Trägers durch Nitrieren bzw. Carbonitrieren im Plasma durchgeführt, da damit Oberflächenschichten mit sehr hoher Kontinuität der Eigenschaften erhalten werden. Zudem ist dieses Verfahren kostengünstig und umweltfreundlich durchzuführen, insbesondere wenn Luft-N₂ verwendet wird.

Auch die Oxidation mit Wasserdampf erhöht die Umweltfreundlichkeit des Verfahrens, wobei zusätzliche Verunreinigungen, wie sie z.B. durch Verwendung von Luftsauerstoff entstehen können, vermieden werden können.

Durch zusätzliches Dotieren der silizium- bzw. germaniumbasierenden Beschichtung zumindest über einen Teilbereich der Schichtdicke mit Kohlenstoff und/oder Stickstoff kann die Verschleißbeständigkeit und die Härte dieser Schicht weiter verbessert werden bzw. kann damit auch die Reibung erniedrigt und die Hitzebeständigkeit erhöht werden. Des Weiteren kann damit die Oberflächenenergie sowie das Benetzungsverhalten, das heißt das Klebeverhalten, weiter erniedrigt werden.

Der Ausdruck "zumindest über einen Teilbereich der Schichtdicke" ist so auszulegen, dass damit auch Schichtsysteme zu verstehen sind, die aus einer Kombination aus SiO₂ bzw. GeO₂ und einer darauf angeordneten Si(Ge)-O-C, Si(Ge)-O-N und/oder Si(Ge)-O-C-N Schicht bestehen. Si-O-C/N bzw. Ge-O-C/N ist dabei nicht zwingend stöchiometrisch gemeint. Deren Herstellung kann durch entsprechende Gaszusammensetzung und Variation dieser Zusammensetzung während des Abscheidens erfolgen.

Es ist dabei von Vorteil, wenn der Kohlenstoffgehalt in der silizium- bzw. germaniumbasierenden Beschichtung auf einen Wert eingestellt wird, der ausgewählt ist aus einem Bereich mit einer unteren Grenze von 1 Atom-% und einer oberen Grenze von 100 Atom-%. Vorzugsweise wird der Kohlenstoffgehalt auf einen Wert eingestellt, der ausgewählt ist aus einem Bereich mit einer unteren Grenze von 1 Atom-% und einer oberen Grenze von 25 Atom-%, bzw. ausgewählt aus einem Bereich mit einer unteren Grenze von 5 Atom-% und einer oberen Grenze von 15 Atom-%.

Die Angabe 100 Atom-% ist so zu verstehen, dass damit ein Wechsel des Beschichtungssystems erfolgt, also nicht mehr Silizium oder Germanium bzw. die Oxide hiervon den relativen Hauptanteil der Beschichtung bilden, sondern zu einer Minoritätskomponente über den Beschichtungsquerschnitt werden, wobei dies soweit durchgeführt werden kann, dass praktisch reine DLC-Schichten aus C auf der Oberfläche abgeschieden werden. Dieser Wechsel kann, wie dies später noch beschrieben wird, in Form eines Gradienten oder stufenweise erfolgen, sodass eine "Multilayer" Struktur entsteht, mit unterschiedlicher Zusammensetzung der Schichten, wobei der Gehalt an Si oder Ge abnimmt und der Gehalt an C und/oder N zunimmt. Es ist also beispielsweise ein gradierter Weg von einer "reinen" Oxidschicht, z.B. SiO₂ oder GeO₂, durch Zunahme des Anteils an Kohlenstoff und Abnahme des Anteils an Sauerstoff ein Wechsel zu einer Si- bzw. Ge-DLC Schicht im Rahmen der Erfindung möglich.

Der Stickstoffgehalt in der silizium- bzw. germaniumbasierenden Beschichtung kann eingestellt werden auf einen Wert der ausgewählt ist aus einem Bereich mit einer unteren Grenze von 1 Atom-%, insbesondere 2 Atom-% vorzugsweise Atom-3% und einer oberen Grenze von 60 Atom-%, insbesondere 10 Atom-% vorzugsweise 5 Atom-%. In Hinblick auf den Anteil 60 Atom-% wird auf obige Ausführungen zu hohen Anteilen an Kohlenstoff verwiesen.

Zur weiteren Verbesserung dieser Eigenschaften, insbesondere der Oberflächenhärte und der Verschleißbeständigkeit bzw. des Haftvermögens der Silizium- bzw. Germanium- bzw. Siliziumdioxid bzw. Germaniumdioxidschicht auf der Oxidschicht des Trägers ist es von Vorteil wenn für die Dotierung mit Kohlenstoff und Stickstoff in dieser Schicht ein Konzentrationsgradient eingestellt wird. Dabei ist es von Vorteil, wenn der Kohlenstoff- und/oder Stickstoffgehalt ausgehend von den, dem Träger nahen Oberflächenschichten in Richtung auf die äußere Oberflächenschicht der Schicht, also jener Oberfläche, welche dem Träger abgewandt ist, zunimmt. Der Konzentrationsgradient kann dabei linear ansteigend oder nicht linear ansteigend, bspw. mit einem exponentiellen Verlauf, eingestellt werden. Es ist dabei möglich, dass der Gehalt an Kohlenstoff von 1 Atom- % bis auf einen Wert 100 Atom-% zunimmt. Ebenso ist es möglich, dass der Stickstoffgehalt von einem Wert von 1 Atom- % auf einen Wert von 10 Atom-% zunimmt.

Es sei an dieser Stelle erwähnt, dass, obwohl die Konzentrationszunahme von Stickstoff und/oder Kohlenstoff die bevorzugte Variante ist, es im Rahmen der Erfindung aber auch möglich ist, dass die Konzentrationsgradienten von Kohlenstoff und Stickstoff abnehmen bzw. dass der Konzentrationsgradient von Kohlenstoff zunimmt und der von Stickstoff abnimmt bzw. dass der Konzentrationsgradient von Stickstoff zunimmt und jener von Kohlenstoff abnimmt. Es können mit diesen Variationen entsprechende Modifikationen der Eigenschaften, insbesondere jener Eigenschaften, welche bereits oben stehend erwähnt wurden, in Hinblick auf den jeweiligen Verwendungszweck des erfindungsgemäßen Werkstücks verändert werden. Des Weiteren sei an dieser Stelle erwähnt, dass die Prozentangaben auf die Summe an Silizium- bzw. Germanium(di)oxid bzw. Silizium bzw. Germanium mit Dotierungselement(en) bzw. Dotierungsstoff(en) bezogen sind.

In einer Variante hierzu ist es möglich, den Gesamtgehalt an Dotierungsstoffen bzw. Dotierungselementen, insbesondere an Kohlenstoff und Stickstoff, auf einen Maximalwert von beschränkt wird, der ausgewählt ist aus einem Bereich mit einer unteren Grenze von 5 Atom-% und einer oberen Grenze von 60 Atom-%, bzw. ausgewählt ist aus einem Bereich mit einer unteren Grenze von 10 Atom-% und einer oberen Grenze von 30 Atom-%, wiederum bezogen auf den Silizium- bzw. Germanium(di)oxid- bzw. Silizium- bzw. Germaniumgehalt mit Dotierungselementen.

Die Abscheidung der silizium- bzw. germaniumbasierenden Beschichtung erfolgt bevorzugt mit einer gepulsten Gleichspannung. Es kann damit eine Überhitzung des Werkstückes vermieden werden, in dem die in das Werkstück eingebrachten Energie über die Dauer der Pulse bzw. die Dauer der Pulspausen entsprechend variiert wird. Bevorzugt werden Pulse ausgewählt mit einer Amplitude die ausgewählt ist aus einem Bereich mit einer unteren Grenze 300 V und einer oberen Grenze 1500 V sowie einer Pulsdauer mit einer unteren Grenze von 0,1 µs und einer oberen Grenze von 2000 µs bzw. einer Pulspausendauer mit einer unteren Grenze von 0,1 µs und einer oberen Grenze von 2000µs. Dabei können die Spannungspulse sowohl zumindest annähernd rechteckig verlaufend oder aber mit einer steil ansteigenden Flanke und/oder einer steil abfallenden Flanke bzw. Mischformen daraus verwendet werden. Die Spannungspulse können sowohl eine positive als auch eine negative Amplitude aufweisen.

Im Rahmen der Erfindung ist es aber auch möglich die Abscheidung mittels Wechselspannung bzw. dipolarer Spannung bzw. dipolaren Pulsen oder mit Hochfrequenzquellen durchzuführen.

Bevorzugt wird auch das Plasmanitrieren bzw. Plasmanitrocarburieren mit einer gepulsten Gleichspannung durchgeführt und damit ebenfalls eine Überhitzung des Werkstückes während der Behandlung im Plasma vermieden bzw. wird damit eine entsprechende Temperaturkontrolle der Behandlung ermöglicht. Die entsprechenden Werte für die Amplitude der Spannung bzw. die Form der aufgebrachten Impulse und die Dauer der Pulse bzw. der Pulspausen kann dabei ebenfalls aus obig genannten Wertebereichen ausgewählt sein.

Die Schichtdicke der, gegebenenfalls dotierten, Silizium- bzw. Silizium(di)oxid- bzw. Germanium- bzw. Germanium(di)oxidbeschichtung wird bevorzugt auf einen Wert eingestellt der ausgewählt ist aus einem Bereich mit einer unteren Grenze von 1 µm und einer oberen Grenze von 25 µm. Unterhalb von 1 µm ist die Sicherheit für die Erreichung oben genannter Eigenschaften der Beschichtung nicht mehr durchgängig gewährleistbar. Über 25 µm konnte hingegen keine weitere Verbesserung der Eigenschaften beobachtet werden. Vielmehr konnte beobachtet werden, dass bei sehr hohen Schichtdicken, beginnend ab ca. 50 µm, ein teilweises Abplatzen der Beschichtung auftritt.

Insbesondere wird die Schichtdicke auf einen Wert eingestellt, der ausgewählt ist aus einem Bereich mit einer unteren Grenze von 1 µm und einer oberen Grenze von 20 µm, vorzugsweise auf einen Wert der ausgewählt ist aus einem Bereich mit einer unteren Grenze von 2 µm und einer oberen Grenze von 10 µm.

Die Nitrierung und/oder Oxidation der oberflächennahen Bereiche des Trägers und Ausbildung einer Diffusionszone und einer Verbindungsschicht wird bis zu einer Schichtdicke, ausgehend von der Oberfläche des Trägers, durchgeführt, die ausgewählt ist aus einem Bereich mit einer unteren Grenze von 3 µm und einer oberen Grenze von 50 µm.

Insbesondere wird diese Schichtdicke, in der der Gehalt an Stickstoff und/oder Sauerstoff des Trägers erhöht ist, ausgewählt aus einem Bereich mit einer unteren Grenze von 5 µm und einer oberen Grenze von 40 µm, vorzugsweise ausgewählt aus einem Bereich mit einer unteren Grenze von 10 µm und einer oberen Grenze von 30 µm.

Zur Erhöhung der elektrischen Leitfähigkeit bzw. um eine bessere Haftung der, gegebenenfalls dotierten, silizium- bzw. germaniumbasierten Schicht auf dem Träger zu erreichen, ist es möglich diese Beschichtung mit zumindest einem metallischen Element zu dotieren. Beispielsweise kann dieses metallische Element ein Weichmetall, wie z.B. Zinn oder Indium, sein, um damit auch die Reibung zu reduzieren. Andere Elemente können bspw. sein Titan, Chrom, Eisen, Aluminium, Nickel, Kobalt, Molybdän, Gold, Niob, Vanadium, Platin, Palladium.

Es ist aber auch möglich, diese, gegebenenfalls dotierte, silizium- bzw. germaniumbasierte Schicht mit zumindest einem weiteren nichtmetallischen Element zu dotieren, wie bspw. Fluor oder Bor, um die Adhäsion weiter zu verringern, bspw. in dem die Oberflächenenergie weiter reduziert wird.

Besonders vorteilhaft ist es, wenn die Nitrierung, die Oxidation und das Abscheiden der Beschichtung in einer einzigen Beschichtungsanlage, insbesondere einer Plasmaanlage, durchgeführt wird, um damit zeitaufwendige Zwischenschritte für das Aus- und Einschleusen in verschiedene Anlagen zu vermeiden. Insbesondere in Hinblick auf Plasmaanlagen wird damit der Vorteil erhalten, dass das so genannte up - scaling einfacher durchführbar ist, da diese Anlagen bereits einen sehr große Verbreitung in der Beschichtungstechnik haben und somit hinreichend beherrscht werden. Es lässt sich damit eine entsprechende verfahrenstechnische Vereinfachung erzielen. Es ist auch eine einzige Anlage umfassend bzw. bestehend aus einem Plasma- und einem Gasnitrierungsteil möglich.

Obwohl bei entsprechender Verfahrensgestaltung die Oberfläche hinsichtlich der Topographie unverändert belassen werden kann, ist es von Vorteil, zur Erniedrigung der Reibung und damit zur Verbesserung der Tribologie der erfindungsgemäßen Werkstücke, wenn eine dem Träger abgewandte Oberfläche der Beschichtung eine Oberflächentopographie mit Erhebungen aufweist, die annähernd kugelabschnitts- bzw. kugelförmig ausgebildet sind. Besonders vorteilhaft für die tribologisch verbesserten Eigenschaften des Werkstücks und damit für deren Verwendung in tribologisch beanspruchten Baugruppen ist es, wenn diese Oberflächenstrukturierung zumindest rosenkohlartig, also mit dicht nebeneinander liegenden bzw. sich zumindest teilweise überdeckenden kugelabschnittförmigen Erhebung ausgebildet ist. Dabei können der arithmetische Mittenrauwert Ra bzw. die maximale Rauheitsprofilhöhe nach DIN EN ISO 4287 gleich bleiben, und nur die Oberflächenstruktur - im Vergleich zur Oberfläche des Trägers - verändert werden oder auch erniedrigt werden bei gleichzeitiger Änderung der Oberflächenstruktur.

Im Hinblick auf diese spezielle Oberflächenstruktunerung, insbesondere wenn diese rosenkohlartig ausgebildet ist, sei angemerkt, dass damit auch eine Verbesserung der Verschmutzungsneigung derartig beschichteter Werkstücke erreicht werden kann, wobei in gewisser Weise ein so genannter selbstreiningender Effekt in Art des Lotuseffektes auftritt.

Des Weiteren ist diese Oberflächenstruktur auch vorteilhaft in Hinblick darauf, dass die silizium- bzw. germaniumbasierte Beschichtung auch als Haftschicht bzw. Zwischenschicht für weitere Beschichtungen, insbesondere DLC-Schichten, auf dem Träger fungiert.

Die Erfindung betrifft weiters die Verwendung des Werkstücks als tribologisch beanspruchtes Bauelement. Insbesondere für Anwendungen unter dynamischer Reibung, also von Reibung die auftritt, wenn zwei Bauteile relativ zueinander bewegt werden, können verbesserte Eigenschaften erzielt werden.

Wie bereits oben erwähnt betrifft die Erfindung auch die Verwendung des Werkstücks als Substrat für weitere Beschichtungen, wobei die Beschichtung als Haftvermittlerschicht wirkt.

Aufgrund des Zusammenwirkens von Oxidschicht auf dem Träger und der silizium- bzw. germaniumbasierten Beschichtung auf dieser Oxidschicht können verbesserte Korrosionsbeständigkeiten zur Verfügung gestellt werden, sodass also die Erfindung auch die Verwendung des Werkstücks in korrosiven Medien betrifft.

Weiters betrifft die Erfindung die Verwendung des Werkstücks als zerspannendes Werkzeug, wobei die entsprechenden Härteeigenschaften sowie wiederum die tribologischen Eigenschaften des Werkstücks im Vordergrund stehen.

Schließlich betrifft die Erfindung aber auch die Verwendung des Werkstücks als Formwerkzeug, insbesondere wegen deren verminderter Adhäsionsneigung. Zum besseren Verständnis der Erfindung wird diese anhand der nachfolgenden Beispiele näher erläutert.

Es zeigen dabei jeweils in schematisch vereinfachter Darstellung
- Fig. 1: Einen Querschnitt durch die oberflächennahen Bereiche eines Ausschnittes eines erfindungsgemäßen Werkstücks;
- Fig. 2: ein GDEOS Tiefenprofil eines beschichteten Trägers;
- Fig. 3: einen Oberflächenausschnitt mit rosenkohlartiger Obertlächentopografie.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind bei einer Lageänderung sinngemäß auf die neue Lage zu übertragen. Weiters können auch Einzelmerkmale oder Merkmalskombinationen aus den gezeigten und beschriebenen unterschiedlichen Ausführungsbeispielen für sich eigenständige, erfinderische oder erfindungsgemäße Lösungen darstellen.

Des Weiteren wird festgehalten, dass in der nachfolgenden Beschreibung nur mehr auf siliziumbasierte Schichten eingegangen wird, die Ausführungen aber entsprechend übertragbar auf germanium- sowie Mischungen aus silizium- und germaniumbasierte Schichten sind.

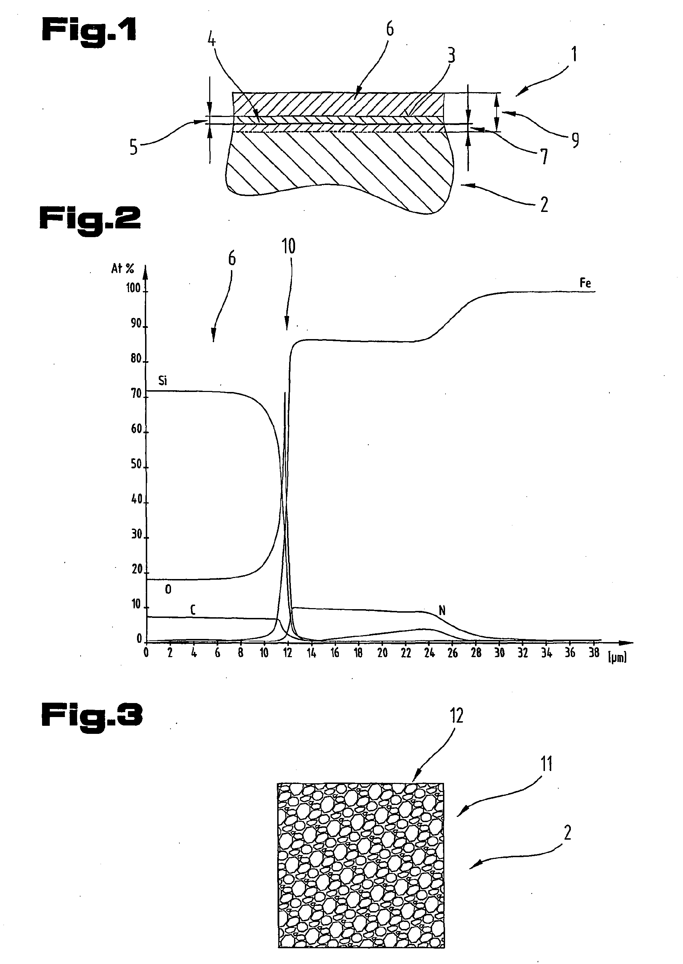

Fig. 1 zeigt einen Ausschnitt aus eines erfindungsgemäßen Werkstück 1 umfassend einen metallischen Träger 2, der eine Oberfläche 3 aufweist. Diese Oberfläche 3 ist durch ein Oxid 4 gebildet, welches aus zumindest einem Teil des Werkstoffes des Trägers 2 durch oxidierende Behandlung gebildet wurde. Das Oxid 4 ist bis zu einer Schichtdicke 5 im Bereich der Oberfläche 3 ausgebildet. Auf dieser Oberfläche 3 ist eine Beschichtung 6 niedergeschlagen, die aus, gegebenenfalls dotiertem, insbesondere amorphen, Silizium bzw. Siliziumdioxid besteht. Diese Beschichtung 6 weist insbesondere eine diamantähnliche Struktur auf, wodurch diese siliziumbasierende Schicht eine sehr hohe Härte erhält. Insbesondere kann diese Härte einen Wert annehmen, der ausgewählt ist aus einem Bereich mit einer unteren Grenze von HV 250 und einer oberen Grenze von HV 5500, gemessen mit einer Prüfkraft von 30 mN.

Unterhalb der Schicht aus dem Oxid 4 ist bis zu einer Schichtdicke 7 eine Schicht mit erhöhtem Stickstoffgehalt im Vergleich zum Rest des Trägers 2 ausgebildet. Diese Schicht wird im Folgenden Stickstoffschicht 8 genannt.

Die Stickstoffschicht 8 und die Schicht aus dem Oxid 4 bilden zusammen mit der Beschichtung 6 ein Schichtsystem 9.

Der Träger wird bei diesem Ausführungsbeispiel durch einen Vergütungs- oder Baustahl gebildet. Diese Werkstoffe sind vergleichsweise weich, sodass sie entsprechenden Belastungen ungenügend standhalten. Zur Erhöhung der Härte, insbesondere der Oberflächenhärte, ist es aus dem Stand der Technik bereits bekannt, eine Nitrierung dieser Oberfläche 3 durchzuführen. Beispielsweise kann diese Nitrierung über Plasmanitrieren erfolgen, indem zum Beispiel ein Stickstoff Wasserstoffgemisch verwendet wird, wobei durch das Plasma Reaktionen ausgelöst werden, die zur Bindung von Stickstoff an der Oberfläche führen. Dieser Stickstoff diffundiert in der Folge aufgrund der hohen Temperatur des Stahls während der Behandlung (ca. 450°C bis 600°C) in die Werkstoffobertläche unter Ausbildung einer verschleißfesten Nitridschicht. Es können damit Härtewerte von bis zu 1200 HV erreicht werden. Die Schichtdicke 7 sowie die Härte können durch geeignete Wahl der Prozessparameter gesteuert werden. Neben der Erhöhung der Verschleißfestigkeit wird darüber hinaus bereits eine gewisse höhere Korrosionsbeständigkeit des Trägers 2 erreicht. Die Nitrierung des Trägers 2, das heißt der Oberflächenschicht, kann prinzipiell mit jeder geeigneten Art, welche aus dem Stand der Technik bekannt ist, durchgeführt werden. Beispielsweise kann die Nitrierung durch Gasnitrierung oder Nitrierung im Salzbad erfolgen, wie dies aus dem Stand der Technik bekannt ist. Als Prozessgase können beispielsweise auch N₂, NH₃, N₂H₂, NH₃N₃, NH₄N₃ verwendet werden.

Als Prozessgas für das Plasmanitrokarburieren kann Methan vermischt mit Kohlendioxid oder anderen Kohlenstoffspendern, wie zum Beispiel C₂H₂, verwendet werden.

Durch das Nitrieren entstehen vorrangig Fe₄N-Verbindungsschichten bzw. Fe₂₋₃N.

Bevorzugt wird im Rahmen der Erfindung jedoch die plasmaaktivierte chemische Gasphasenabscheidung (PACVD-Technik) angewandt. Ebenso bevorzugt ist die so genannte PE-CVD-Technik (Plasma enhanced chemical vapor deposition), wie sie bereits aus dem Stand der Technik bekannt ist und beispielsweise bei "S. Fujimaki, et al.; New DLC coating method using magnetron plasma in an unbalanced magnetic field; vacuum 59,2000,657-664" beschrieben ist.

Anstelle der Nitrierung ist es weiters möglich, im PlasmaverFahren den Träger 2 einer Karbonitrierung zu unterziehen.

Da über die Beschichtung 6, welche beispielsweise durch Silizium, insbesondere amorphen Silizium oder Siliziumdioxid, insbesondere amorphen, Siliziumdioxid gebildet ist, dem Träger 2, das heißt dem Werkstück 1 insgesamt, die erforderliche Härte gegeben wird, ist es im Rahmen der Erfindung auch möglich, auf die Nitrierung des Trägers 2 zu verzichten und beispielsweise ausschließlich eine Schicht aus dem Oxid 4 an den Träger 2 auszubilden.

Für die Oxidation der Oberflächenschicht wird bevorzugt Wasserdampf verwendet. Im Rahmen der Erfindung ist es aber auch möglich, andere Sauerstoffspender wie zum Beispiel reinen Sauerstoff, Ozon, oder CO₂ zu verwenden.

Durch die Oxidation dieses Eisenwerkstoffes entstehen oberflächlich vorrangig Fe₃O₄-Phasen.

Es sei darauf hingewiesen, dass diese Phasen selbstverständlich beschränkt sind auf Eisenwerkstoffe, und entstehen bei anderen Werkstoffen für den Träger 2 andere Nitrid- und Oxidphasen.

Die Oxidation kann auch gleichzeitig mit der Nitrierung erfolgen, wenn z.B. NO, NO₂, N₂O, N₂O₄, N₂O₅ oder NO₃ als Prozessgas verwendet wird.

Die Beschichtung 6 kann beispielsweise durch reines Silizium beziehungsweise reines Siliziumdioxid gebildet sein. Ebenso kann sowohl das Silizium als auch das Siliziumdioxid wie bereits oben dargestellt, dotiert sein. Des Weiteren ist es möglich, dass diese siliziumbasierende Schicht amorph beziehungsweise kristallin ausgebildet ist. Insbesondere von Vorteil ist es in Hinblick auf die Verschleißbeständigkeit, wenn diese Beschichtung 6 ähnliche Eigenschaften aufweist wie die kohlenstoffbasierenden Schichten, die unter der Bezeichnung DLC bekannt sind. Derartige Schichten werden auch als DLC-Si Schichten bezeichnet. Diese Schichten sind bereits der Literatur beschrieben, bspw. in oben zitierter Literatur.

Als Werkstoff für den Träger 2 kommt auch Aluminium, Chrom, Molybdän, Gold, Indium, Niob, Mangan, Titan, Platin, Palladium und Tellur sowie Legierungen dieser Metalle in betracht.

Bevorzugt wird im Rahmen der Erfindung sowohl das Nitrieren als auch das Oxidieren sowie das Aufdampfen der Beschichtung 6 in nur einer Plasmaanlage durchgeführt. Derartige Plasmaanlagen sind bereits im Stand der Technik ausreichend beschrieben und werden z.B. von der Anmelderin bereits seit Jahren vertrieben. Dem gemäß ist die Verfahrenstechnik hinreichend bekannt, sodass an dieser Stelle auf die einschlägige Literatur, wie bspw. "Ruth Chatterjee-Fischer et al., Wärmebehandlung von Eisenwerkstoffen, Nitrieren und Nitrocarburieren, 2. Auflage, 1995, expert Verlag", diesbezüglich verwiesen sein soll. Die Plasmabehandlung wird bekannter Weise in einem Rezipienten durchgeführt, der evakuierbar ausgestattet ist und über entsprechende Gaszuführungen sowie Absaugungen sowie die entsprechenden Einbauten wie z.B. die Elektroden, Gasumlenkungen, etc. verfügt.

Hinsichtlich der Verfahrensweise selbst ist es möglich das Nitrieren und/oder die Herstellung der Beschichtung 6 mittels Gleichspannung oder bevorzugt mittels gepulster Gleichspannung oder mittels Wechselspannung durchzuführen.

Figur 2 zeigt ein GDOES-Tiefenprofil durch die oberflächennahen Bereiche des Trägers 2 nach Figur 1. Es ist dabei auf der Abszisse die Schichtdicke in Mikrometer angegeben und auf der Ordinate die Konzentration der jeweiligen Elemente in Atom-%. Es ist deutlich zu sehen, dass die Schichtdicke der Beschichtung 6 nach Fig. 1 ca. 12 µm beträgt und diese aus mit Kohlenstoff dotiertem Siliziumdioxid besteht. In einer Übergangszone 10 ist der Sauerstoffpeak, welcher das Oxid 4 nach Fig. 1 kennzeichnet, ersichtlich. Im rechten Teil dieser Darstellung überwiegt der Eisengehalt, wobei bis zu einer Schichtdicke von ca. 25 µm diese Schicht zusätzlich noch Stickstoff und Kohlenstoff enthält.

Obwohl diese Darstellung schematisch zu verstehen ist, entsprechen die einzelnen Kurven einer realen Aufnahme und sind entsprechende Fehler darin aufgrund der zeichnerischen Darstellung zur Unterstützung dieser Beschreibung der Erfindung entstanden. Das heißt mit anderen Worten, dass die angegebene Konzentrationswerte bzw. aus dieser Figur ersichtlichen Konzentrationswerte, wenn überhaupt, nur mit geringer Abweichung der Realität entsprechen.

Für die Herstellung derartiger Schichten können folgende Prozessparameter - in Abhängigkeit der Anlagengröße - verwendet werden:
Druck: 10 Pa bis 1000 Pa
Spannung: 300 V bis 1500 V

Hexamethyldisiloxan (HMDSO), Tetramethylsilan (TMS), Si-/Ti-Precourser: 0,11/h bis 100 1/h
H₂: 0 l/h bis 400 l/h
O₂: 0 l/h bis 400 l/h
N₂: 0 l/h bis 400 l/h
Ar: 0 l/h bis 100 l/h
C₂H₂: 0 l/h bis 100 l/h
CH₄: 0 l/h bis 100 l/h
Abscheidetemperatur: 600 °C - 20 °C
Pulszeiten negativ/positiv: 0,1 µs bis 2000 µs
Pausenzeiten: 0 µs bis 2000 µs

Im speziellen wurde das Schichtsystem 9 nach Fig. 1 und Fig. 2 mit folgenden Parametern hergestellt:
Druck: 100 Pa
Spannung: 1000 V

Hexamethyldisiloxan (HMDSO), Tetramethylsilan (TMS), Si-/Ti-Precourser: 10 l/h
H₂: 50 l/h
O₂: 20 l/h
N₂: 100 l/h
Ar: 100 l/h
C₂H₂: 10 l/h
CH₄: 10 l/h

Abscheidetemperatur: 450 °C-150 °C
Pulszeiten positiv: 150 µs
Pausenzeiten: 200 µs

Als Kohlenwasserstoffquelle kann neben CH₄ bzw. C₂H₂ auch C₂H₆, C₃H₈, C₄H₁₀, etc. herangezogen werden.

Neben Argon kann als Verdünnungsgas auch Wasserstoff, Helium oder Neon verwendet werden.

Wie bereits oben erwähnt, erfolgt die Oxidation bevorzugt mit Wasserdampf.

Es sei an dieser Stelle darauf hingewiesen, dass zur Vermeidung unnötiger Wiederholungen an dieser Stelle nicht mehr im Besonderen auf die bereits oben erwähnten Dotierungselemente, seien sie nichtmetallischer als auch metallischer Natur, Bezug genommen wird. Es sei hierzu auf obige Ausführung verwiesen.

Die Herstellung des Schichtsystems erfolgt bevorzugt durch Abscheidung aus der Gasphase.

Fig. 3 zeigt schließlich eine schematische REM-Aufnahme eines Oberflächenausschnittes 11 des Trägers 2 nach Figur 1. Sehr deutlich ist darin eine rosenkohlartige Oberflächentopographie 12 erkennbar. Diese Oberflächentopographie 12 ist besonders bevorzugt in Hinblick auf tribologische Anwendungen des Werkstücks 1.

Wie bereits erwähnt, kann durch geeignete Prozessführung, bspw. durch Variation von Spannung und/oder Temperatur und/oder Druck die Oberflächenstruktur der Beschichtung 6 so gewählt werden, dass nicht nur diese bevorzugt rosenlcohlartige Oberflächentopographie 12 entsteht sondern dass die ursprünglichen Oberflächenrauhigkeit der nitrierten und/oder oxidierten Oberfläche des Trägers 2 nachgebildet wird. Ebenso ist es möglich, durch geeignete Wahl der Prozessparameter eine möglichst glatte Oberfläche zu erreichen.

Bevorzugt werden keine hohen Abscheidetemperaturen angewandt, wenn amorphe Schichten hergestellt werden sollen.

Das erfindungsgemäße Schichtsystem 9 kann, wie bereits oben stehend ausgeführt, vielseitig verwendet werden. Beispielsweise findet dieses System Anwendung in der Waffenindustrie, in der Kolbenindustrie, in der Hydraulik-/Pneumatikzylinderindustrie, im Formenbau, insbesondere für die Kunststoffindustrie bzw. zur Herstellung von Aluminiumbauteilen, in der Zerspanungsindustrie sowie in der Holzverarbeitung. Beispielsweise können Gasdruckdämpfer, Stoßdämpfer für PKW, LKW, Hydraulikzylinder bspw. für Baumaschinen, Hydraulikblöcke, Pneumatikzylinder, Bauteile der Motor- bzw. Getriebeindustrie, wie z.B. Nockenwellen, Schlepphebel, Tassenstössel, Zylinderbuchsen, Kolbenringe, Synchronringe, Schaltwellen, Kupplungsflansche (insbesondere Druckplatten), Schaltgestänge, Ganghebel und Anlaufscheiben bzw. im Fahrzeugbau allgemein, bspw. für Bremskolben, Motorradgabeln, landwirtschaftliche Fahrzeuge, Gelenksteile, Radnaben, Kugelköpfe (insbesondere Radaufhängungen), am Werkzeugsektor für Bohrer, bspw. Gewindebohrer, Ziehdorne, Gewindeschneidbacken, Werkzeughalter, im allgemeinen Maschinenbau für Linearführungen, Kugelsysteme, Führungsbolzen, Robotergreifer, bzw. für Waffenteile allgemein sowie für Teile im Schiffbau. Der Vorteil des Schichtsystems 9 liegt nicht nur in einer Verbesserung der mechanischen Eigenschaften bzw. auch gewisser anderer physikalischer Eigenschaften wie z.B. der Temperaturbeständigkeit dieser Werkstücke 1 sondern auch darin, dass, wie bereits einleitend ausgeführt, mit dem erfindungsgemäßen Schichtsystem 9 auch ein besonderer optischer Effekt erreicht wird, insbesondere eine tief schwarze Farbe, welche eine Nachbearbeitung dieser Oberflächen, um eine entsprechende Optik zu erhalten, nicht erforderlich macht.

Sämtliche Angaben zu Wertebereichen in gegenständlicher Beschreibung sind so zu verstehen, dass diese beliebige und alle Teilbereiche daraus mit umfassen, z.B. ist die Angabe 1 bis 10 so zu verstehen, dass sämtliche Teilbereiche, ausgehend von der unteren Grenze 1 und der oberen Grenze 10 mit umfasst sind, d.h. sämtliche Teilbereich beginnen mit einer unteren Grenze von 1 oder größer und enden bei einer oberen Grenze von 10 oder weniger, z.B. 1 bis 1,7, oder 3,2 bis 8,1 oder 5,5 bis 10.

Die Ausführungsbeispiele zeigen bzw. beschreiben mögliche Ausführungsvarianten des Werkstücks 1 bzw. des erfindungsgemäßen Verfahrens, wobei an dieser Stelle bemerkt sei, dass die Erfindung nicht auf die speziell dargestellten Ausführungsvarianten derselben eingeschränkt ist, sondern vielmehr auch diverse Kombinationen der einzelnen Ausführungsvarianten untereinander möglich sind und diese Variationsmöglichkeit aufgrund der Lehre zum technischen Handeln durch gegenständliche Erfindung im Können des auf diesem technischen Gebiet tätigen Fachmannes liegt.

Der Ordnung halber sei abschließend darauf hingewiesen, dass zum besseren Verständnis das Werkstück 1 vereinfacht, teilweise unmaßstäblich und/oder vergrößert und/oder verkleinert dargestellt wurden.

### Bezugszeichenaufstellung

- 1: Werkstück
- 2: Träger
- 3: Oberfläche
- 4: Oxid
- 5: Schichtdicke

- 6: Beschichtung
- 7: Schichtdicke
- 8: Stickstoffschicht
- 9: Schichtsystem
- 10: Übergangszone

- 11: Oberflächenausschnitt
- 12: Oberflächentopographie

## Patentansprüche

1. Verfahren zur Herstellung einer Beschichtung (6) auf Basis zumindest eines Werkstoffes ausgewählt aus einer Gruppe umfassend Silizium, Germanium, sowie die Oxide SiOₓ bzw. GeOₓ dieser Elemente, wobei diese gegebenenfalls dotiert werden, und insbesondere amorph hergestellt werden, auf zumindest einem Teilbereich einer Oberfläche (3) eines metallischen Trägers (2), wobei in dem Träger (2) gegebenenfalls vor der Abscheidung der Beschichtung (6) zumindest im Bereich des Teilbereichs der Gehalt an Stickstoff erhöht wird, **dadurch gekennzeichnet, dass** dieser Teilbereich vor Abscheidung der Beschichtung (6) einer Oxidation unterzogen wird.

2. Verfahren nach Anspruch 1, **dadurch gekennzeichnet, dass** die Oxidation nach der Nitrierung durchgeführt wird.

3. Verfahren nach Anspruch 1 oder 2, **dadurch gekennzeichnet, dass** die Erhöhung des Gehaltes an Stickstoff durch Plasmanitrien oder Plasmanitrocarburieren durchgeführt wird.

4. Verfahren nach einem der vorhergehenden Ansprüche, **dadurch gekennzeichnet, dass** die Oxidation mit Wasserdampf durchgeführt wird.

5. Verfahren nach einem der vorhergehenden Ansprüche, **dadurch gekennzeichnet, dass** die Beschichtung (6) zumindest über einen Teilbereich der Schichtdicke kohlenstoff- und/oder stickstoffdotiert wird.

6. Verfahren nach Anspruch 5, **dadurch gekennzeichnet, dass** in der Beschichtung (6) ein Konzentrationsgradient an Kohlenstoff und/oder Stickstoff eingestellt wird.

7. Verfahren nach einem der vorhergehenden Ansprüche, **dadurch gekennzeichnet, dass** für die Abscheidung der Beschichtung (6) eine gepulste Entladung verwendet wird.

8. Verfahren nach einem der vorhergehenden Ansprüche, **dadurch gekennzeichnet, dass** die Beschichtung (6) in einer Schichtdicke (5) auf dem Träger abgeschieden wird, die ausgewählt ist aus einem Bereich mit einer unteren Grenze von 1 µm und einer oberen Grenze von 25 µm.

9. Verfahren nach einem der vorhergehenden Ansprüche, **dadurch gekennzeichnet, dass** die Nitrierung und/oder Oxidation bis in eine Schichtdicke (7) des Trägers (2) durchgeführt wird, die ausgewählt ist aus einem Bereich mit einer unteren Grenze von 3 µm und einer oberen Grenze von 50 µm.

10. Verfahren nach einem der vorhergehenden Ansprüche, **dadurch gekennzeichnet, dass** die Beschichtung (6) mit zumindest einem metallischen Element dotiert wird.

11. Verfahren nach einem der vorhergehenden Ansprüche, **dadurch gekennzeichnet, dass** die Beschichtung (6) mit zumindest einem weiteren nichtmetallischen Element dotiert wird.

12. Verfahren nach einem der vorhergehenden Ansprüche, **dadurch gekennzeichnet, dass** die Nitrierung, die Oxidation und das Abscheiden der Beschichtung (6) auf der Oberfläche (3) des Trägers 2 in einer einzigen Anlage durchgeführt wird.

13. Werkstück (1), herstellbar nach einem Verfahren nach einem der vorhergehenden Ansprüche, umfassend einen metallischen Träger (2), der auf zumindest einem Teilbereich seiner Oberfläche (3) eine Beschichtung (6) auf Basis zumindest eines Werkstoffes ausgewählt aus einer Gruppe umfassend Silizium, Germanium, sowie die Oxide SiOₓ bzw. GeOₓ dieser Elemente, wobei diese gegebenenfalls dotiert sind, und insbesondere amorph sind, aufweist, wobei der Träger (2) gegebenenfalls zumindest in oberflächennahen Bereichen des Teilbereiches der Oberfläche (3) nitrierend vorbehandelt ist, **dadurch gekennzeichnet, dass** der Träger (2) zumindest in oberflächennahen Bereichen des Teilbereichs der Oberfläche (3) oxidierend vorbehandelt ist.

14. Werkstück (1) nach Anspruch 13, **dadurch gekennzeichnet, dass** die Konzentration an Stickstoff in dem oberflächennahen Bereich ausgewählt ist aus einem Bereich mit einer unteren Grenze von 1 Atom-% und einer oberen Grenze von 30 Atom-%.

15. Werkstück (1) nach Anspruch 13 oder 14, **dadurch gekennzeichnet, dass** die Konzentration ab Sauerstoff in dem oberflächennahen Bereich ausgewählt ist aus einem Bereich mit einer unteren Grenze von 1 Atom-% und einer oberen Grenze von 30 Atom-%.

16. Werkstück (1) nach einem der Ansprüche 13 bis 15, **dadurch gekennzeichnet, dass** das die Beschichtung (6) mit Kohlenstoff und/oder Stickstoff dotiert ist.

17. Werkstück (1) nach Anspruch 16, **dadurch gekennzeichnet, dass** die Konzentration an Kohlenstoff in der Beschichtung (6) ausgewählt ist aus einem Bereich mit einer unteren Grenze von 1 Atom-% und einer oberen Grenze von 100 Atom-%.

18. Werkstück (1) nach Anspruch 16 oder 17, **dadurch gekennzeichnet, dass** die Konzentration an Stickstoff in der Beschichtung (6) ausgewählt ist aus einem Bereich mit einer unteren Grenze von 1 Atom-% und einer oberen Grenze von 60 Atom-%.

19. Werkstück (1) nach einem der Ansprüche 13 bis 18, **dadurch gekennzeichnet, dass** die Beschichtung (6) mit zumindest einem metallischen Element dotiert ist.

20. Werkstück (1) nach einem der Ansprüche 13 bis 19, **dadurch gekennzeichnet, dass** die Beschichtung (6) mit zumindest einem weiteren nicht metallischen Element dotiert ist.

21. Werkstück (1) nach einem der Ansprüche 13 bis 20, **dadurch gekennzeichnet, dass** das die Dotierungselemente in der Beschichtung (6) in Summe eine Konzentration aufweisen, die ausgewählt ist aus einem Bereich mit einer unteren Grenze von 5 Atom-% und einer oberen Grenze von 60 Atom-%.

22. Werkstück (1) nach einem der Ansprüche 13 bis 21, **dadurch gekennzeichnet, dass** eine dem Träger (2) abgewandte Oberfläche der Beschichtung (6) eine Oberflächentopographie (12) mit Erhebung aufweist, wobei die Erhebung annähernd kugelabschnitt- bzw. kugelförmig ausgebildet sind.

23. Werkstück (1) nach Anspruch 22, **dadurch gekennzeichnet, dass** die Oberflächentopographie (12) zumindest annähernd rosenkohlartig ausgebildet ist.

24. Verwendung des Werkstückes (1) nach einem der Ansprüche 13 bis 23 als tribologisch beanspruchtes Bauelement.

25. Verwendung des Werkstückes (1) nach einem der Ansprüche 13 bis 23 als Substrat für weitere Beschichtungen.

26. Verwendung des Werkstückes (1) nach einem der Ansprüche 13 bis 23 in korrosiven Medien.

27. Verwendung des Werkstückes (1) nach einem der Ansprüche 13 bis 23 als zerspanendes Werkzeug.

28. Verwendung des Werkstückes (1) nach einem der Ansprüche 13 bis 23 als Formwerkzeug.

## Claims

1. Method of producing a coating (6) with a base of at least one material selected from a group comprising silicon, germanium and the oxides SiOₓ or GeOₓ of these elements, the latter optionally being doped and in particular produced amorphously, on at least a part-region of a surface (3) of a metallic substrate (2), and the quantity of nitrogen in the substrate (2) is optionally increased prior to depositing the coating (6), at least in the part-region, **characterised in that** this part-region is subjected to a process of oxidation prior to depositing the coating (6).

2. Method as claimed in claim 1, **characterised in that** the oxidation is carried out after nitriding.

3. Method as claimed in claim 1 or 2, **characterised in that** the quantity of nitrogen is increased by plasma nitriding or plasma nitrocarburisation.

4. Method as claimed in one of the preceding claims, **characterised in that** the oxidation is carried out with water vapour.

5. Method as claimed in one of the preceding claims, **characterised in that** the coating (6) is carbon and/or nitrogen-doped through at least a part-region of the coating thickness.

6. Method as claimed in claim 5, **characterised in that** a concentration gradient of carbon and/or nitrogen is set in the coating (6).

7. Method as claimed in one of the preceding claims, **characterised in that** a pulsed discharge is used to deposit the coating (6).

8. Method as claimed in one of the preceding claims, **characterised in that** the coating (6) is deposited on the substrate with a layer thickness (5) selected from a range with a lower limit of 1 µm and an upper limit of 25 µm.

9. Method as claimed in one of the preceding claims, **characterised in that** nitriding and/or oxidation is carried out to a layer thickness (7) of the substrate (2) selected from a range with a lower limit of 3 µm and an upper limit of 50 µm.

10. Method as claimed in one of the preceding claims, **characterised in that** the coating (6) is doped with at least one metallic element.

11. Method as claimed in one of the preceding claims, **characterised in that** the coating (6) is doped with at least one additional non-metallic element.

12. Method as claimed in one of the preceding claims, **characterised in that** the nitriding, oxidation and deposition of the coating (6) on the surface (3) of the substrate (2) is carried out in a single system.

13. Workpiece (1) which can be produced by a method as claimed in one of the preceding claims, comprising a metallic substrate (2), which has on at least a part-region of its surface (3) a coating (6) with a base of at least one material selected from a group comprising silicon, germanium and the oxides SiOₓ and GeOₓ of these elements, the latter optionally being doped and in particular amorphous, and at least a part-region of the substrate (2) close to the surface (3) is pre-treated by nitriding, **characterised in that** the substrate (2) is pre-treated by oxidation at least in areas of the part-region close to the surface (3).

14. Workpiece (1) as claimed in claim 13, **characterised in that** the concentration of nitrogen in the region close to the surface is selected from a range with a lower limit of 1 atomic % and an upper limit of 30 atomic %.

15. Workpiece (1) as claimed in claim 13 or 14, **characterised in that** the concentration of oxygen in the region close to the surface is selected from a range with a lower limit of 1 atomic % and an upper limit of 30 atomic %.

16. Workpiece (1) as claimed in one of claims 13 to 15, **characterised in that** the coating (6) is doped with carbon and/or nitrogen.

17. Workpiece (1) as claimed in claim 16, **characterised in that** the concentration of carbon in the coating (6) is selected from a range with a lower limit of 1 atomic % and an upper limit of 100 atomic %.

18. Workpiece (1) as claimed in claim 16 or 17, **characterised in that** the concentration of nitrogen in the coating (6) is selected from a range with a lower limit of 1 atomic % and an upper limit of 60 atomic %.

19. Workpiece (1) as claimed in one of claims 13 to 18, **characterised in that** the coating (6) is doped with at least one metallic element.

20. Workpiece (1) as claimed in one of claims 13 to 19, **characterised in that** the coating (6) is doped with at least one additional non-metallic element.

21. Workpiece (1) as claimed in one of claims 13 to 20, **characterised in that** the doping elements in the coating (6) have a concentration in total selected from a range with a lower limit of 5 atomic % and an upper limit of 60 atomic %.

22. Workpiece (1) as claimed in one of claims 13 to 21, **characterised in that** a surface of the coating (6) remote from the substrate (2) has a surface topography (12) with a raised area and the raised area has approximately the shape of a sphere segment or sphere.

23. Workpiece (1) as claimed in claim 22, **characterised in that** the surface topography (12) is of a design approximately akin to the shape of a Brussels sprout.

24. Use of the workpiece (1) as claimed in one of claims 13 to 23 as an element subjected to tribological load.

25. Use of the workpiece (1) as claimed in one of claims 13 to 23 as a substrate for further coatings.

26. Use of the workpiece (1) as claimed in one of claims 13 to 23 in corrosive media.

27. Use of the workpiece (1) as claimed in one of claims 13 to 23 as a tool for removing material.

28. Use of the workpiece (1) as claimed in one of claims 13 to 23 as a moulding tool.

## Revendications

1. Procédé pour la préparation d'un revêtement (6) sur la base d'au moins un matériau choisi parmi le groupe comprenant le silicium, le germanium, ainsi les oxydes SiOₓ, respectivement GeOₓ de ces éléments, ces derniers pouvant être dopés le cas échéant et étant préparés en particulier amorphes, sur au moins une zone partielle d'une surface (3) d'un support métallique (2), la teneur en azote dans le support (2) étant le cas échéant augmentée au moins dans le voisinage de la zone partielle de surface avant le dépôt du revêtement (6), **caractérisé en ce que** cette zone partielle est soumise à une oxydation avant le dépôt du revêtement (6).

2. Procédé selon la revendication 1, **caractérisé en ce que** l'oxydation est effectuée après la nitruration.

3. Procédé selon la revendication 1 ou 2, **caractérisé en ce que** l'augmentation de la teneur en azote est effectuée par nitruration au plasma ou par nitrocarburation au plasma.

4. Procédé selon l'une quelconque des revendications précédentes, **caractérisé en ce que** l'oxydation est effectuée par de la vapeur d'eau.

5. Procédé selon l'une quelconque des revendications précédentes, **caractérisé en ce qu'**au moins sur une zone partielle de l'épaisseur de couche, le revêtement (6) est dopé de carbone et/ou d'azote.

6. Procédé selon la revendication 5, **caractérisé en ce qu'**un gradient de concentration en carbone et/ou en azote est ajusté dans le revêtement (6).

7. Procédé selon l'une quelconque des revendications précédentes, **caractérisé en ce que** pour le dépôt du revêtement (6) est utilisée une décharge pulsée.

8. Procédé selon l'une quelconque des revendications précédentes, **caractérisé en ce que** le revêtement (6) est déposé sur le support en une épaisseur de couche (5) qui est choisie dans un intervalle avec une limite inférieure de 1 µm et une limite supérieure de 25 µm.

9. Procédé selon l'une quelconque des revendications précédentes, **caractérisé en ce que** la nitruration et/ou l'oxydation sont effectuées jusqu'à une épaisseur de couche (7) du support (2) qui est choisie dans un intervalle avec une limite inférieure de 3 µm et une limite supérieure de 50 µm.

10. Procédé selon l'une quelconque des revendications précédentes, **caractérisé en ce que** le revêtement (6) est dopé avec au moins un élément métallique.

11. Procédé selon l'une quelconque des revendications précédentes, **caractérisé en ce que** le revêtement (6) est dopé avec au moins un autre élément non métallique

12. Procédé selon l'une quelconque des revendications précédentes, **caractérisé en ce que** la nitruration, l'oxydation et le dépôt du revêtement (6) sur la surface (3) du support (2) sont effectués dans un seule installation.

13. Pièce ouvrée (1), réalisable selon un procédé selon l'une quelconque des revendications précédentes, comprenant un support métallique (2) qui comporte sur au moins une zone partielle de sa surface (3) un revêtement (6) à base d'au moins un matériau choisi parmi un groupe comprenant le silicium, le germanium, ainsi que les oxydes SiOₓ, respectivement GeOₓ de ces éléments, ces derniers étant dopés le cas échéant et étant en particulier amorphes, sachant que le support (2) est prétraité le cas échéant par nitruration au moins dans les zones proches de la surface de la zone partielle de la surface (3), **caractérisée en ce que** le support (2) est prétraité par oxydation au moins dans les zones proches de la surface de la zone partielle de surface (3).

14. Pièce ouvrée (1) selon la revendication 13, **caractérisée en ce que** la concentration d'azote dans la zone proche de la surface est choisie dans un intervalle avec une limite inférieure de 1 atome % et une limite supérieure de 30 atomes %.

15. Pièce ouvrée (1) selon la revendication 13 ou 14, **caractérisée en ce que** la concentration en oxygène dans la zone proche de la surface est choisie dans un intervalle avec une limite inférieure de 1 atome % et une limite supérieure de 30 atomes %.

16. Pièce ouvrée (1) selon l'une quelconque des revendications 13 à 15, **caractérisée en ce que** le revêtement (6) est dopé avec du carbone et/ou de l'azote.

17. Pièce ouvrée (1) selon la revendication 16, **caractérisée en ce que** la concentration en carbone dans le revêtement (6) est choisie dans un intervalle avec une limite inférieure de 1 atome % et une limite supérieure de 100 atomes %.

18. Pièce ouvrée (1) selon la revendication 16 ou 17, **caractérisée en ce que** la concentration en azote dans le revêtement (6) est choisie dans un intervalle avec une limite inférieure de 1 atome % et une limite supérieure de 60 atomes %.

19. Pièce ouvrée (1) selon l'une quelconque des revendications 13 à 18, **caractérisée en ce que** le revêtement (6) est dopé avec au moins un élément métallique.

20. Pièce ouvrée (1) selon l'une quelconque des revendications 13 à 19, **caractérisée en ce que** le revêtement (6) est dopé avec au moins un autre élément non métallique

21. Pièce ouvrée (1) selon l'une quelconque des revendications 13 à 20, **caractérisée en ce que** les éléments de dopage dans le revêtement (6) présentent dans leur somme une concentration qui est choisie dans un intervalle avec une limite inférieure de 5 atomes % et une limite supérieure de 60 atomes %.

22. Pièce ouvrée (1) selon l'une quelconque des revendications 13 à 21, **caractérisée en ce qu'**une surface du revêtement (6) détournée du support (2) présente une topographie superficielle (12) avec des saillies, les saillies étant à peu près de la forme d'un segment de sphère, respectivement sphériques.

23. Pièce ouvrée (1) selon la revendication 22, **caractérisée en ce que** la topographie superficielle (12) est au moins en partie formée à la manière de choux de Bruxelles.

24. Utilisation de la pièce ouvrée (1) selon l'une quelconque des revendications 13 à 23, comme composant sollicité par frottement.

25. Utilisation de la pièce ouvrée (1) selon l'une quelconque des revendications 13 à 23, comme substrat pour des revêtements supplémentaires.

26. Utilisation de la pièce ouvrée (1) selon l'une quelconque des revendications 13 à 23, dans des milieux corrosifs.

27. Utilisation de la pièce ouvrée (1) selon l'une quelconque des revendications 13 à 23, comme outil à enlèvement de copeaux

28. Utilisation de la pièce ouvrée (1) selon l'une quelconque des revendications 13 à 23, comme outil de formage.
